# EUROPEAN PATENT APPLICATION

(11) **EP 4 697 898 A1**
(43) Date of publication of application: **18.02.2026**
(21) Application number: 25194491.4
(22) Date of filing: 07.08.2025
(51) Int. Cl.: H10D 88/00, H10D 84/83, H10D 84/01, H10D 30/01, H10D 30/00

(54) **SEMICONDUCTOR DEVICE INCLUDING FILL FRONTSIDE CONTACT STRUCTURE**

(30) Priority: 14.08.2024 US 202463683100 P; 18.02.2025 US 202519055928
(71) Applicant: SAMSUNG ELECTRONICS CO., LTD., Yeongtong-gu Suwon-si, Gyeonggi-do 16677 (KR)
(72) Inventor: SHIN, Jongmin, San Jose, CA, 95134 (US); LIM, Jinyoung, San Jose, CA, 95134 (US); SEO, Kang-ill, San Jose, CA, 95134 (US)
(74) Representative: Kuhnen & Wacker Patent- und Rechtsanwaltsbüro PartG mbB

(57) **Abstract**

Provided is a semiconductor device which includes: a 1^{st} field-effect transistor, FET, including a 1^{st} source/drain pattern; a 2^{nd} FET including a 2^{nd} source/drain pattern, vertically above the 1^{st} FET; a 1^{st} side spacer on a right surface of the 1^{st} source/drain pattern, the 1^{st} side spacer comprising an isolation material; and a frontside contact structure on a right surface of the 2^{nd} source/drain pattern and a right surface of the 1^{st} side spacer, wherein the frontside contact structure is connected to the 2^{nd} source/drain pattern and is isolated from the 1^{st} source/drain pattern by the 1^{st} side spacer.

## Description

### BACKGROUND

### 1. Field

Apparatuses and methods consistent with the disclosure relate to a stacked semiconductor device in which a contact structure is buried between active patterns.

### 2. Description of Related Art

A stacked field-effect transistor (FET) device has been introduced in response to increased demand for a semiconductor device having a high device density and performance. The stacked FET device may include a 1^{st} FET at a 1^{st} level and a 2^{nd} FET at a 2^{nd} level above the 1^{st} level, where each of the two FETs may be a fin field-effect transistor (FinFET), a nanosheet transistor, a forksheet transistor, or any other types of FET. The stacked FET device formed of the FinFETs, nanosheet transistors, or forksheet transistors may also be referred to as a three-dimensional stacked (3D-stacked) semiconductor device.

The FinFET has one or more fin structures, which are protruded from a substrate, as a channel structure and a gate structure surrounding at least three surfaces of each of the fin structures. The nanosheet transistor is characterized by one or more nanosheet channel layers, which are vertically stacked or arranged on a substrate, as a channel structure and a gate structure surrounding all four surfaces of each of the nanosheet channel layers. The nanosheet transistor is referred to as a gate-all-around (GAA) transistor or a multi-bridge channel field-effect transistor (MBCFET). The forksheet transistor is a combination of two nanosheet transistors with an isolation wall therebetween. In the forksheet transistor, nanosheet channel layers of each nanosheet transistor are formed at each side of the isolation wall and pass through a gate structure in parallel with the isolation wall.

In addition to the stacked FET device, a backside power distribution network (BSPDN) has also been introduced to address a heavy traffic of signal lines and power rails, high device density, and increased contact resistance between structural elements of the stacked FET device at the front side of the semiconductor device. Here, the front side refers to a side where a transistor structure including a channel structure, a gate structure, and source/drain patterns is formed with respect to a top surface of a substrate, and the back side refers to a side opposite the front side. The BSPDN is formed on a back side of a semiconductor device, and may include backside metal lines, such as a buried power rail connected to a voltage source and a buried signal line connected to another circuit element. Further, the BSPDN may include backside contact structures connecting source/drain patterns of the semiconductor device to the buried power rails or signal lines though the back side of the semiconductor device. The BSPDN structure may be more useful to manufactured the stacked FET devices.

The stacked FET devices may be implemented in a standard cell and manufactured based on the layout of the semiconductor cell. However, as the cell height of the standard cell including the stacked FET devices becomes smaller and smaller to respond to the increased demand for high-density semiconductor devices, formation of contact structures connecting the source/drain regions of the stacked FET devices to the buried power rails or signal lines exposes various risks including increased contact resistance and misaligned connections between device elements.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a stacked FET device in which a fill frontside contact structure is formed to contact a side surface of an upper source/drain pattern and a side spacer formed on a side surface of a lower source/drain pattern to be isolated from the lower source/drain pattern. This fill frontside contact structure may be formed in a semiconductor device with a reduced cell height in a simplified process.

According to an aspect of the disclosure, there is provided a semiconductor device which may include: a 1^{st} FET including a 1^{st} source/drain pattern; a 2^{nd} FET including a 2^{nd} source/drain pattern, vertically above the 1^{st} FET; a 1^{st} side spacer on a right side surface of the 1^{st} source/drain pattern, the 1^{st} side spacer comprising an isolation material; and a frontside contact structure on a right side surface of the 2^{nd} source/drain pattern and a right side surface of the 1^{st} side spacer, wherein the frontside contact structure is connected to the 2^{nd} source/drain pattern and is isolated from the 1^{st} source/drain pattern by the 1^{st} side spacer.

According to an aspect of the disclosure, there is provided a semiconductor device which may include: a 1^{st} FET including a 1^{st} source/drain pattern; a 2^{nd} FET including a 2^{nd} source/drain pattern, vertically above the 1^{st} FET; a 3^{rd} FET including a 3^{rd} source/drain pattern, at a right side of the 1^{st} FET; a 4^{th} FET including a 4^{th} source/drain pattern, vertically above the 3^{rd} FET; and a frontside contact structure contacting a right side surface of the 2^{nd} source/drain pattern and a left side surface of the 4^{th} source/drain pattern, wherein a left side surface of the 1^{st} source/drain pattern is not vertically overlapped by the 2^{nd} source/drain pattern, and a right side surface of the 3^{rd} source/drain pattern is not vertically overlapped by the 4^{th} source/drain pattern.

According to an aspect of the disclosure, there is provided a semiconductor device which may include: a 1^{st} FET including a 1^{st} source/drain pattern; a 2^{nd} FET at a right side of the 1^{st} FET, the 2^{nd} FET including a 2^{nd} source/drain pattern; and a frontside contact structure contacting a right side surface of the 1^{st} source/drain pattern and a left side surface of the 2^{nd} source/drain pattern, wherein the frontside contact structure is a single continuum metal structure, and the frontside contact structure connects the source/drain pattern of the 1^{st} FET and the source/drain pattern of the 2^{nd} FET to a frontside metal line or a backside metal line.

According to an aspect of the disclosure, there is provided a semiconductor device which may include: a 1^{st} FET including a 1^{st} source/drain pattern; a 2^{nd} FET including a 2^{nd} source/drain pattern vertically above the 1^{st} source/drain pattern; and a common contact structure connecting the 1^{st} source/drain pattern and the 2^{nd} source/drain pattern, wherein the common contact structure has a greater width than each of the 1^{st} source/drain pattern and the 2^{nd} source/drain pattern.

According to an aspect of the disclosure, there is provided a method of manufacturing a semiconductor device, which may include: providing a 1^{st} semiconductor stack including a 1^{st} stack and a 2^{nd} stack vertically above the 1^{st} stack, each of the 1^{st} stack and the 2^{nd} stack including at least one channel layer; forming a 1^{st} side spacer on a right side surface of the 1^{st} stack; forming a 1^{st} source/drain pattern based on the 1^{st} stack; forming a 2^{nd} source/drain pattern based on the 2^{nd} stack; and forming a frontside contact structure on a right side surface of the 2^{nd} source/drain pattern and a right side surface of the 1^{st} side spacer so that the frontside contact structure is connected to the 2^{nd} source/drain pattern and isolated from the 1^{st} source/drain pattern.

### BRIEF DESCRIPTION OF DRAWINGS

Example embodiments of the disclosure will be more clearly understood from the following detailed description taken in conjunction with the accompanying drawings.
FIG. 1A is a layout of a semiconductor cell for stacked FET devices with frontside contact structures and backside contact structures, and FIG. 1B is a cross-section view of a semiconductor device including two stacked FET devices formed in the semiconductor cell of FIG 1A taken along a line I-I' shown in FIG. 1A, according to one or more embodiments.
FIG. 2A is a layout of a semiconductor cell for stacked FET devices with a fill frontside contact structure and backside contact structures, FIG. 2B is a cross-section view of a semiconductor device including two stacked FET devices formed in the semiconductor cell of FIG 2A taken along a line I-I' shown in FIG. 2A, and FIG. 2C is a cross-section view of a semiconductor device including two stacked FET devices formed in the semiconductor cell of FIG 2A taken along a line III-III' shown in FIG. 2A, according to one or more embodiments.
FIG. 3 illustrates a semiconductor device including a fill frontside contact structure formed between two stacked FET devices, according to one or more embodiments.
FIGS. 4A-4L illustrate intermediate semiconductor devices obtained after respective steps of manufacturing a semiconductor device in which a fill frontside contact structure is formed between two stacked FET devices having respective channel structures having different number of nanosheet layers and different widths, according to one or more embodiments.
FIGS. 5A and 5B are a flowchart of manufacturing a semiconductor device including a stacked FET device in which a fill frontside contact structure is formed, according to one or more embodiments.
FIG. 6 is a schematic block diagram illustrating an electronic device including one or more semiconductor devices in which a plurality of different types of FET device are formed, according to one or more embodiments.

### DETAILED DESCRIPTION

All of the embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element of the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," 2% "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element may be a "right" element and a "left" element when a device or structure including these elements are differently oriented.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element described in the descriptions of an embodiment could be termed a 2^{nd} element in the descriptions of another element or one or more claims, and vice versa without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c.

Herein, the terms of degree including "substantially" or "about" may be used. In one or more examples, when specifying that a parameter X may be substantially the same as parameter Y, the term "substantially" may be understood as X being within 10% of Y. In one or more examples, when specifying that a parameter is about X, the term "about" may be understood as being within 10% of X. Still, when a term "same" is used to compare parameters of two or more elements, the term may cover "substantially same" parameters.

It will be understood that, when the term "contact" is used to describe two metal elements, for example, a metal line and a via structure, a barrier metal layer such as titanium (Ti), tantalum (Ta), titanium nitride (TiN), tantalum nitride (TaN), tungsten nitride (WN), nickel nitride (NiN), cobalt nitride (CoN), or platinum nitride (PtN), not being limited thereto, may be formed therebetween. Further, it will be understood that, when a metal contact structure is described as being formed on or contact a surface of a source/drain pattern, a silicide layer such as cobalt silicide (CoSi₂), nickel silicide (NiSi₂), titanium silicide (TiSi₂), or tungsten silicide (WSi₂), not being limited thereto, may be formed therebetween.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

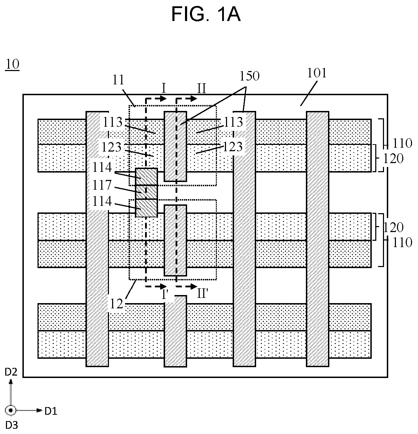

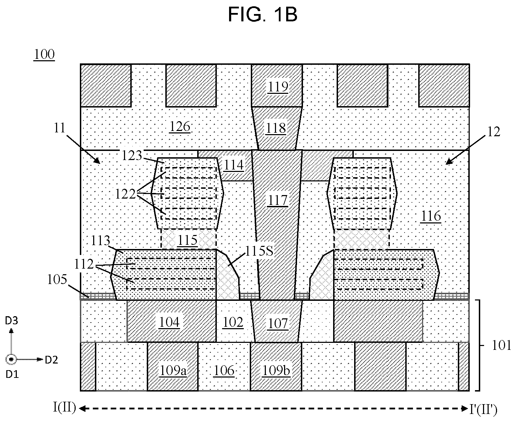

FIG. 1A is a layout of a semiconductor cell for stacked FET devices with frontside contact structures and backside contact structures, and FIG. 1B is a cross-section view of a semiconductor device including two stacked FET devices formed in the semiconductor cell of FIG 1A taken along a line I-I' shown in FIG. 1A, according to one or more embodiments.

It is to be understood that FIG. 1A is provided to show positional relationships between structural elements of the stacked FET devices, and thus, some structural elements such as frontside isolation structures, metal lines and via structures may not be shown therein for brevity purposes. Further, in order to assist better understanding of the stacked FET devices, FIG. 1B also shows some structural elements (e.g., channel structures) of the stacked FET devices that can be seen at a cross-section view taken along line II-II' using dashed lines.

Referring to FIG. 1A, a semiconductor cell 10 may include a plurality of 1^{st} active patterns 110 and 2^{nd} active patterns 120 extended in a D1 direction and arranged in a D2 direction intersecting the D1 direction. The 2^{nd} active patterns 120 may be stacked on the 1^{st} active patterns 110 in a D3 direction intersecting the D1 and D2 directions, and partially overlap the 1^{st} active patterns 110 in the D3 direction, respectively. Thus, the 1^{st} active pattern 110 partially overlapped by the 2^{nd} active pattern 120 may have a greater width in the D2 direction than the 2^{nd} active pattern 120. In the semiconductor cell 10 may also be formed a plurality of gate structures 150 arranged in the D1 direction and extended in the D2 direction across the active patterns 110 and 120. The semiconductor cell 10 shown in FIG. 1A may include a plurality of stacked FET devices, a plurality of different types of active device, and a plurality of passive devices, not being limited thereto.

The D1 direction refers to a channel-length direction in which a current flows between two source/drain patterns connected to each other through a channel structure, the D2 direction is a channel-width direction or a cell-height direction, and the D3 direction is a channel-thickness direction. The D1 and D2 directions may each be referred to as a horizontal direction and the D3 direction may be referred to as a vertical direction.

Referring to FIGS. 1A and 1B, a semiconductor device 100 may include a 1^{st} stacked FET device 11 and a 2^{nd} stacked FET device 12 facing each other in the D2 direction on a base layer 101. The semiconductor device 100 may be formed in the semiconductor cell 10. The two stacked FET devices 11 and 12 of the semiconductor device 100 may be formed at a same level in the D3 direction on the base layer 101. Also, the two stacked FET devices 11 and 12 may have the same structural elements, and thus, only those of the 1^{st} stacked FET device 11 may be described herebelow. The base layer 101 may include a backside isolation structure which is formed by replacing a silicon (Si)-based substrate and include a plurality of backside contact structures and a plurality of backside metal lines to be described later.

Each stacked FET device may include a 1^{st} FET, which may be an n-type field-effect transistor (NFET), and a 2^{nd} FET, which may be a p-type field-effect transistor (PFET). However, the disclosure is not limited thereto. According to one or more other embodiments, the 1^{st} FET may be a PFET and the 2^{nd} FET may be an NFET, and both of the 1^{st} FET and the 2^{nd} FET may be a PFET or an NFET.

The 1^{st} FET and the 2^{nd} FET may be formed based on one of the 1^{st} active patterns 110 and one of the 2^{nd} active patterns 120 stacked thereon in the D3 direction along with a corresponding gate structure 150. This gate structure 150 may be divided into two gate structures by a gate-cut structure respectively to form the 1^{st} stacked FET device 11 and the 2^{nd} stacked FET device 12.

The 1^{st} active pattern 110 for the 1^{st} FET may form a 1^{st} channel structure 112 and 1^{st} source/drain patterns 113 at a 1^{st} level of the 1^{st} stacked FET device 11. The 1^{st} channel structure 112 may include a plurality of 1^{st} nanosheet layers epitaxially grown from a silicon-based substrate therebelow, and thus, the 1^{st} nanosheet layers may also be formed of silicon. The 1^{st} source/drain patterns 113 of n-type may be epitaxially grown from the 1^{st} nanosheet layers of the 1^{st} channel structure 112, and may be formed of silicon doped with n-type impurities (e.g., phosphorus (P), arsenic (As), or antimony (Sb)). The 1^{st} channel structure 112 may be surrounded by a gate structure 150 which controls current flow between the 1^{st} source/drain patterns 113 through the 1^{st} channel structure 112. The gate structure 150 may include a gate dielectric layer surrounding the 1^{st} nanosheet layers, a 1^{st} work-function metal layer formed on the gate dielectric layer, and a gate electrode formed on the 1^{s} work-function metal layer. Thus, the 1^{st} channel structure 112 including the 1^{st} nanosheet layers, the 1^{st} source/drain patterns 113 and the gate structure 150 may form the 1^{st} FET of the 1^{s} stacked FET device 11 as an NFET implemented by a nanosheet transistor at the 1^{st} level of the 1^{s} stacked FET device 11.

The 2^{nd} active pattern 120 for the 2^{nd} FET may form a 2^{nd} channel structure 122 and 2^{nd} source/drain patterns 123 at a 2^{nd} level vertically above the 1^{st} level in the D3 direction. The 2^{nd} channel structure 122 may include a plurality of 2^{nd} nanosheet layers also epitaxially grown from the silicon-based substrate, and thus, the 2^{nd} nanosheet layers may also be formed of silicon. The 2^{nd} source/drain patterns 123 may be epitaxially grown from the 2^{nd} nanosheet layers of the 2^{nd} channel structure 122, and may be formed of silicon germanium (SiGe) doped with p-type impurities (e.g., boron (B), gallium (Ga), or indium (In)). The 2^{nd} channel structure 122 may also be surrounded by the gate structure 150 which controls current flow between the 2^{nd} source/drain patterns 123 through the 2^{nd} channel structure 122. The gate dielectric layer surrounding the 1^{st} channel structure 112 may be extended to also surround the 2^{nd} channel structure 122, and a 2^{nd} work-function metal layer may be formed on this gate dielectric layer, and further, the gate electrode on the 1^{st} work-function metal layer may also be extended to surround the 2^{nd} work-function metal layer. Thus, the 2^{nd} channel structure 122 including the 2^{nd} nanosheet layers, the 2^{nd} source/drain patterns 123 and the gate structure 150 may form the 2^{nd} FET of the 1^{st} stacked FET device 11 as a PFET implemented by a nanosheet transistor at the 2^{nd} level of the 1^{st} stacked FET device 11.

As described earlier, the 2^{nd} active pattern 120 has a smaller width in the D2 direction than the 1^{st} active pattern 110. Accordingly, the 2^{nd} nanosheet layers forming the 2^{nd} channel structure 122 of the 2^{nd} FET may have a smaller width in the D2 direction than the 1^{st} nanosheet layers forming the 1^{st} channel structure 112 of the 1^{st} FET, and the 2^{nd} channel structure 122 may only partially overlap the 1^{st} channel structure 112 in the D3 direction. For example, right side surfaces of the 2^{nd} nanosheet layers may be aligned or coplanar with right side surfaces of the 1^{st} nanosheet layers in the D3 direction, while left side surfaces of the 2^{nd} nanosheet layers are not aligned or coplanar with left side surfaces of the 1^{st} nanosheet layers in the D3 direction. Thus, the 2^{nd} source/drain patterns 123 epitaxially grown from the 2^{nd} nanosheet layers may also be formed to have a smaller width in the D2 direction than the 1^{st} source/drain patterns 113 epitaxially grown from the 1^{st} nanosheet layers. Further, the left side surface of a 1^{st} source/drain pattern 113 may not be overlapped by the 2^{nd} source/drain pattern 123. This width difference of the source/drain patterns provides a free space above a top surface of each of the 1^{st} source/drain patterns 113 which is not vertically overlapped by the 2^{nd} source/drain pattern 123 so that other circuit elements such as a source/drain contact structure may be formed through this space to contact at least a portion of the top surface of the 1^{st} source/drain pattern 113. The foregoing characteristics of the channel structures and the source/drain patterns may be provided to address increasing demands for a high device density in a semiconductor device including stacked FET devices.

In some embodiments, the 2^{nd} channel structure 122 forming the 2^{nd} FET may have a greater number of nanosheet layers than that of the 1^{st} channel structure 112 forming the 1^{st} FET such that the two FETs may have the same or substantially same effective channel width (W_{eff}). For example, the 2^{nd} channel structure 122 may have three nanosheet layers while the 1^{st} channel structure 112 have two nanosheet layers.

The different channel widths and the different number of nanosheet layers, that is, channel layers, may facilitate optimization of the stacked FET devices in the semiconductor cell 10 in terms of not only area gain for a high-density semiconductor device but also device performance such as current speed, work load distribution, power efficiency, contact resistance, thermal control, structural stability, etc.

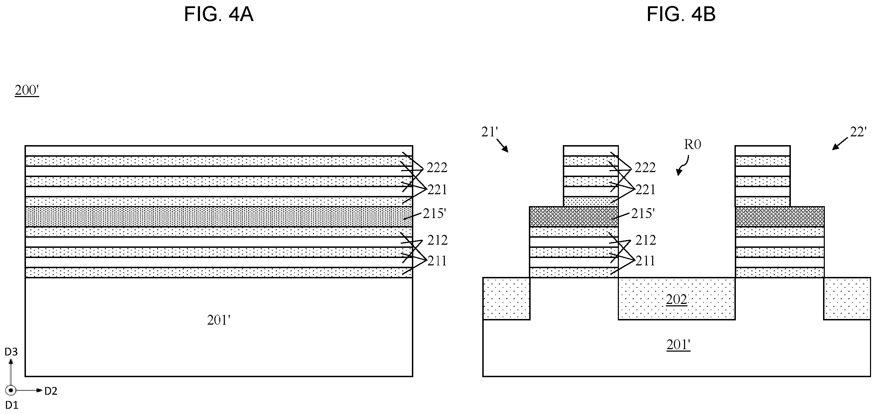

The 1^{st} channel structure 112 and the 2^{nd} channel structure 122 may be isolated from each other through a middle isolation layer 115 which may be formed of an isolation or insulation material such as SiBCN, SiCN, SiOC, SiOCN, Si₃N₄, etc. Further, a side spacer 115S may be disposed on a right side surface of the 1^{st} source/drain pattern 113 as a residual structure of the middle isolation layer 115 which remains after the middle isolation layer 115 replaces a middle sacrificial layer formed between the two channel structures 112 and 122 during the formation of the 1^{st} stacked FET device 11. The side spacer 115S may be disposed only on the right side surface among the two side surfaces of the 1^{st} source/drain pattern 113. This is because, when the 1^{st} active pattern 110 and the 2^{nd} active pattern 120 are patterned to form a space where the source/drain patterns 113 and 123 are to be formed, the middle isolation layer 115 formed on the two active patterns 110 and 120 to replace the middle sacrificial layer between two channel structures 112 and 122 may also be patterned. At this time, a portion of the middle isolation layer 115 only on a right side surface of the 1^{st} active pattern 110, which is vertically aligned or coplanar with a right side surface of the 2^{nd} active pattern 120 thereabove, may remain as the side spacer 115S due to the width difference between the two active patterns 110 and 120 and partial vertical overlapping of the 1^{st} channel structure 112 by the 2^{nd} channel structure 122. Thus, when the 1^{st} source/drain pattern 113 is formed in the patterned space, the right side surface of the 1^{st} source/drain pattern 113 may contact the side spacer 115S so that the side spacer 115 is disposed on the right side surface of the 1^{st} source/drain pattern 113. For the same manner, another side spacer may be disposed only on a left side surface of a 1^{st} source/drain pattern 113 of the 2^{nd} stacked FET device 12. The side spacer 115S may be connected to the middle isolation layer 115 disposed between the two channel structures 112 and 122. The formation of the side spacer 115S will be further described later in reference to FIGS. 4A-4L.

The 1^{st} stacked FET device 11 may be surrounded by a 1^{st} frontside isolation structure 116 to be isolated from another semiconductor device. The 1^{st} frontside isolation structure 116 may be formed of a low-k dielectric material such as silicon oxide (e.g., SiO₂).

On a back side of the 1^{st} stacked FET device 11 may be formed a BSPDN structure including a backside contact structure 104 and a plurality of backside metal lines including backside metal lines 109a and 109b. The backside contact structure 104 may be formed on a bottom surface of the 1^{st} source/drain pattern 113 and connected to a backside metal line 109 buried in a backside isolation structure 106. The backside contact structure 104 may connect the 1^{st} source/drain pattern 113, which is of n-type, to a negative voltage source (or ground) through the backside metal line 109a in a case the backside metal line 109a is used as a power rail. Subject to a circuit design, the backside metal line 109a may be used as a backside signal line to connect the 1^{st} source/drain pattern 113 to another circuit element through the backside contact structure 104 for signal routing purposes. The backside contact structure 104 may take a form of a pillar as a via structure vertically connecting, for example, two metal lines extended in the D1 direction or D2 direction at different vertical levels in the D3 direction. In contrast, the backside metal line 109 may be extended in the D1 direction beyond a length of the 1^{st} source/drain pattern 113 in the D1 direction.

At least a portion of the backside contact structure 104 may be formed between shallow trench isolation (STI) structures 102 which isolate the 1^{st} stacked FET device 11 from an adjacent semiconductor device such as the 2^{nd} stacked FET device 12. The STI structures 102 may be formed of a low-k dielectric material such as silicon oxide (e.g., SiO₂).

As the 1^{st} source/drain pattern 113 may be connected to the negative voltage source or another circuit element through the backside metal line 109a as described above, the 2^{nd} source/drain pattern 123 may also be connected to the backside metal line 109b isolated from the backside metal line 109a on the backside contact structure 104 in the backside isolation structure 106.

To connect the 2^{nd} source/drain pattern 123 to the other backside metal line 109b, a 1^{st} via structure 107 may be formed between the STI structures 102 and a 2^{nd} via structure 117 connected to the 1^{st} via structure 107 may be formed in the 1^{st} frontside isolation structure 116, respectively. Further, a frontside contact structure 114 may be formed on an upper-right edge portion of the 2^{nd} source/drain pattern 123 to be horizontally extended and connected to the 2^{nd} via structure 117. Depending on a selected process, the frontside contact structure 114 may be formed first on the upper-right edge portion of the 2^{nd} source/drain pattern 123, followed by the formation of the 1^{st} via structure 107 and the 2^{nd} via structure 117. A bottom liner 105 may be formed on portions of top surfaces of the STI structures 102 and the 1^{st} via structure 107. The bottom liner 105 may be used as etch stop layer in a process of manufacturing the semiconductor device 100. A material forming the bottom liner 105 may be silicon nitride (SiN, Si₃N₄, etc.).

The 2^{nd} via structure 117 may also be connected to a frontside metal line 119 through a 3^{rd} via structure 118 in a 2^{nd} frontside isolation structure 126. This connection may be provided to relay power or a signal delivered from the back side of the semiconductor device 100 to the 2^{nd} source/drain pattern 123 and to another circuit element through the frontside metal line 119. The frontside metal line 119 may also be extended in the D1 direction beyond a length of the 2^{nd} source/drain pattern 123 in the D1 direction.

The contact structures 104 and 114, the via structures 107, 117 and 118, and the metal lines 109 and 119 may be formed of the same metal or a metal compound or different metal or metal compounds, which may be, for example, tungsten (W), copper (Cu), aluminum (Al), molybdenum (Mo), ruthenium (Ru), etc., or a compound thereof. The isolation structures 116 and 126 may be formed of a low-k material such as silicon oxide (e.g., SiO₂).

As indicated earlier, the 2^{nd} stacked FET device 12 facing the 1^{st} stacked FET device 11 in the semiconductor cell 10 may have the same structure as the 1^{st} stacked FET device 11, and thus, may include the same structural elements such as the 1^{st} channel structure 112, the 2^{nd} channel structure 122, the 1^{st} source/drain pattern 113, and the 2^{nd} source/drain pattern 123 to form a 1^{st} FET and a 2^{nd} FET of the 2^{nd} stacked FET device 12.

The 2^{nd} FET of the 2^{nd} stacked FET device 12 may also be connected to the positive voltage source, and for this purpose, the same frontside contact structure 114 may be formed on an upper-left edge portion of the 2^{nd} source/drain pattern 123 of the 2^{nd} stacked FET device 12 and connected to the 2^{nd} via structure 117. For example, when the 1^{st} stacked FET device 11 and the 2^{nd} stacked FET device 12 may each form an inverter circuit, the 2^{nd} source/drain pattern 123 of p-type of each of the two stacked FET devices 11 and 12 may be connected to the positive voltage source through the 2^{nd} via structure 117, the 1^{st} via structure 107 and the backside metal line 109b therebelow. At this time, the 1^{st} source/drain patterns 113 of n-type of the two stacked FET devices 11 and 12 may be connected to the negative voltage source or ground through the backside contact structures 104 and the backside metal lines 109a therebelow, respectively, to form the inverter circuit.

To connect the 2^{nd} source/drain patterns 123 of the two stacked FET devices 11 and 12 to the same 2^{nd} via structure 117 through the respective frontside contact structures 114, the 2^{nd} stacked FET device 12 may be formed to face the 1^{st} stacked FET 11 in a symmetric manner in the D2 direction. Further, to shorten a distance between the two stacked FET devices 11 and 12, that is, to reduce a cell height, sides of the two stacked FET devices 11 and 12, at which side surfaces of the 1^{st} channel structure 112 and the 2^{nd} channel structure 122 are vertically aligned or coplanar, may face each other in the D2 direction.

However, as the cell height is reduced to respond to the demand of a high-density semiconductor device, formation of the 2^{nd} via structure 117 between the two stacked FET devices 11 and 12 may become more challenging at least because of the high aspect ratio. Thus, the following embodiments may provide a further improved stacked FET device structure.

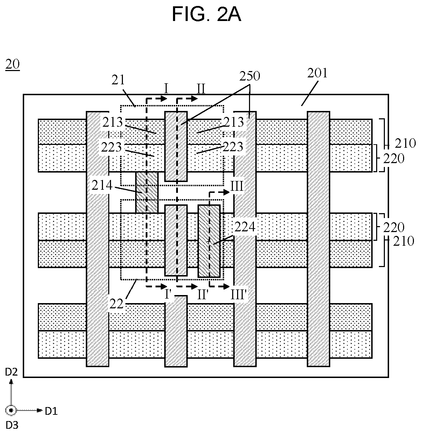

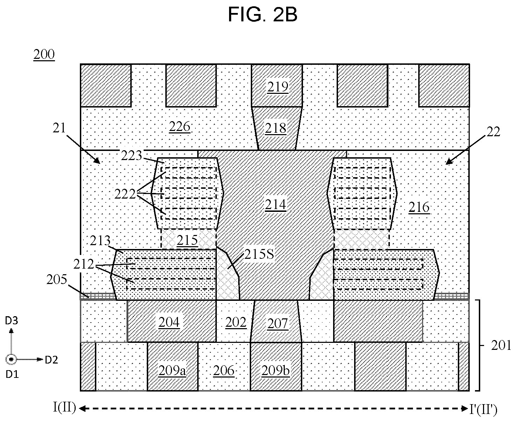

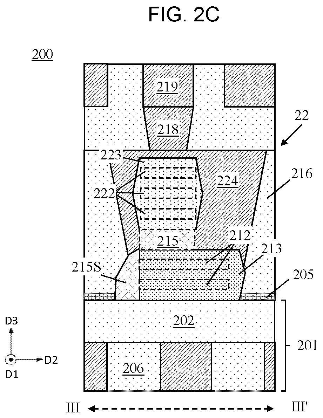

FIG. 2A is a layout of a semiconductor cell for stacked FET devices with a fill frontside contact structure and backside contact structures, FIG. 2B is a cross-section view of a semiconductor device including two stacked FET devices formed in the semiconductor cell of FIG 2A taken along a line I-I' shown in FIG. 2A, and FIG. 2C is a cross-section view of a semiconductor device including two stacked FET devices formed in the semiconductor cell of FIG 2A taken along a line III-III' shown in FIG. 2A, according to one or more embodiments.

It is to be understood that FIG. 2A, like the FIG. 1A, is provided to show positional relationships between structural elements of the stacked FET devices, and thus, some structural elements such as frontside isolation structures, metal lines and via structures may not be shown therein for brevity purposes. Further, in order to assist better understanding of the stacked FET devices, FIG. 2B also shows some structural elements (e.g., channel structures) of the stacked FET devices that can be seen at a cross-section view taken along line II-II' using dashed lines.

Referring to FIG. 2A corresponding to FIG. 1A, a semiconductor cell 20 may include a plurality of 1^{st} active patterns 210 and 2^{nd} active patterns 220 stacked thereon and a plurality of gate structures 250 which may be the same as or correspond to the 1^{st} active patterns 110, the 2^{nd} active patterns 120 and the gate structures 150 of the semiconductor cell 10 of FIG. 1A.

Further, referring to FIG. 2B, a semiconductor device 200 may be formed of a 1^{st} stacked FET device 21 and a 2^{nd} stacked FET device 22 which are the same as or similar to the corresponding stacked FET devices 11 and 12 of the semiconductor device 100, respectively. For example, each of the two stacked FET devices 21 and 22 may include a 1^{st} channel structure including 1^{st} channel layers 212, a 1^{st} source/drain pattern 213, a middle isolation layer 215 and a side spacer 215S, a 2^{nd} channel structure including 2^{nd} channel layers 222, and a 2^{nd} source/drain pattern 223, which are the same as or similar to the corresponding structural elements of the semiconductor device 100. The semiconductor device 200 may also include a base layer 201 including STI structures 202 and a backside isolation structure 206 in which backside contact structures 204, a backside via structure 207 and a plurality of backside metal lines including backside metal lines 209a and 209b are formed. In addition, the semiconductor device 200 may include a 1^{st} front isolation structure 216 and a 2^{nd} frontside isolation structure 226 which includes a frontside via structure 218 and frontside metal lines 219. A bottom liner 205 used as etch stop layer may be formed on portions of top surfaces of the STI structures 202.

Since these structural elements of the semiconductor cell 20 and the semiconductor device 200 are the same as or similar to the corresponding ones of the semiconductor cell 10 and the semiconductor device 100, duplicate descriptions of the same structural elements may be omitted herein, and instead, different aspects of the semiconductor device 200 may be described herein.

In the semiconductor device 200, a fill frontside contact structure 214 may be formed to fill in a space between the two stacked FET devices 21 and 22 in the D2 direction to contact a right side surface and a right portion of a top surface of the 2^{nd} source/drain pattern 223 of the 1^{st} stacked FET device 11 and a left side surface and a left portion of a top surface of the 2^{nd} source/drain pattern 223 of the 2^{nd} stacked FET device 22. This fill frontside contact structure 214 is a replacement of the frontside contact structures 114 and the 2^{nd} via structure 117 included in the semiconductor device 100.

The fill frontside contact structure 214 may contact the side spacer 215S on a right side surface of the 1^{st} source/drain pattern 213 of the 1^{st} stacked FET device 21 and the side spacer 215S on a left side surface of the 1^{st} source/drain pattern 213 of the 2^{nd} stacked FET device 22. Here, the two side spacers 215S may be used as an isolation structure between the fill frontside contact structure 214 and each of the 1^{st} source/drain patterns 213 of the two stacked FET devices 21 and 22. The fill frontside contact structure 214 may also contact the middle isolation layer 215 of each of the two stacked FET devices 21 and 22, thereby contacting an entire right side surface of the 1^{st} stacked FET device 21 and an entire left side surface of the 2^{nd} stacked FET device 22. For example, the fill frontside contact structure 214 may contact entire side surfaces of the side spacers 215S, the middle isolation layers 215 and the 2^{nd} source/drain patterns 223 facing in the D2 direction.

The fill frontside contact structure 214 may fill in the space between the two stacked FET devices 21 and 22 in the D2 direction such that no portion of the 1^{st} frontside isolation structure 216 is left between the two stacked FET devices 21 and 22 in the semiconductor device 200, unlike in the semiconductor device 100 as shown in FIG. 1B. The fill frontside contact structure 214 may be a replacement of the frontside contact structures 114 and the 2^{nd} via structure 117 included in the semiconductor device 100. As described later in reference to FIGS. 4A-4L, the fill frontside contact structure 214 may be formed in a single deposition process, and thus, may be a single continuum metal structure (i.e, without a connection surface, interface or junction therein such as one formed between the frontside contact structure 114 and the 2^{nd} via structure 117 in the semiconductor device 100) connecting the 2^{nd} source/drain pattern 223 to the backside via structure 207.

As the fill frontside contact structure 214 is formed between the two stacked FET devices 21 and 22 in the above-described manner, a complicated process of patterning (e.g., dry etching or wet etching) the 1^{st} frontside isolation structure 116 to form the 2^{nd} via structure 117 having a high aspect ratio in the patterned 1^{st} frontside isolation structure 116 may be avoided even when the distance between the two stacked FET devices 11 and 12 in the D2 direction, that is, the cell height, is reduced. This will be further described later in reference to FIGS. 4A-4L. Moreover, as the fill frontside contact structure 214 may have a greater volume than the frontside contact structure 114 and the 2^{nd} via structure 117, a contact resistance may be reduced to improve at least connection performance of the semiconductor device 200. The fill frontside contact structure 214 may be formed of the same metal or metal compound forming the frontside contact structure 114 or the 2^{nd} via structure 117.

Thus, the 1^{st} source/drain patterns 213 of the two stacked FET devices 21 and 22 may be connected to the positive voltage source or another circuit element through the fill frontside contact structure 214 connected to a backside metal line 209b through the backside via structure 207, corresponding to the 1^{st} via structure 107 of the semiconductor device 100. The fill frontside contact structure 214 may also be connected to a frontside metal line 219 through the frontside via structure 218, corresponding to the 3^{rd} via structure 118 of the semiconductor device 100, to relay power or a signal to another circuit element through a frontside metal line 219.

In the meantime, as the 1^{st} source/drain pattern 213 and the 2^{nd} source/drain pattern 223 shown in FIG. 2B form source regions of the NFET and the PFET of the 2^{nd} stacked FET device 22, respectively, the 1^{st} source/drain pattern 213 and the 2^{nd} source/drain pattern 223 shown in FIG. 2C form drain regions of the same NFET and PFET of the 2^{nd} stacked FET device 22, respectively. Thus, when the 2^{nd} stacked FET device 22 forms an inverter circuit, for example, the 1^{st} source/drain pattern 213 and the 2^{nd} source/drain pattern 223 shown in FIG. 2C may form a common output node of the inverter circuit, in which case, a common contact structure may be formed to connect the two drain regions as shown in FIG. 2C.

Referring to FIG. 2C, a common contact structure 224 may be formed in the 1^{st} frontside isolation structure 216 to connect the 1^{st} source/drain pattern 213 and the 2^{nd} source/drain pattern 223 to another circuit element to output a common output signal of the 2^{nd} stacked FET device 22.

The common contact structure 224 may be formed to contact top and two side surfaces of the 2^{nd} source/drain pattern 223, at least a top surface of the 1^{st} source/drain pattern 213 not overlapped by the 2^{nd} source/drain pattern 223, and an upper-right side surface of the 1^{st} source/drain pattern 213. Thus, a width of the common contact structure 224 in the D2 direction may be greater than a width of the 2^{nd} source/drain pattern 223 in the same direction. Thus, it may be easier to etch the 1^{st} frontside isolation structure 216 to form a recess in which the common contact structure 224 is to be formed. Further, as the contact area of the common contact structure 224 on the source/drain patterns 213 and 223 increase, the common contact structure 224 may enable reduction of contact resistance to improve device performance of the 2^{nd} stacked FET device 22. Like the fill frontside contact structure 214 shown in FIG. 2B, the common contact structure 224 may also be formed in a single deposition process, and thus, may be formed as a single continuum metal structure without a connection surface, interface or junction therein.

Referring back to FIG. 2B, the fill frontside contact structure 214 fills in a space between the two stacked FET devices 21 and 22 each of which is formed of two stacked FETs having the differently-sized 1^{st} and the 2^{nd} channel structures with different number of channel layers. However, the disclosure is not limited thereto. A fill frontside contact structure similar to the fill frontside contact structure 214 may also be formed between two stacked FET devices each of which is formed of two stacked FETs having the same-size 1^{st} and the 2^{nd} channel structures with the same number of channel layers.

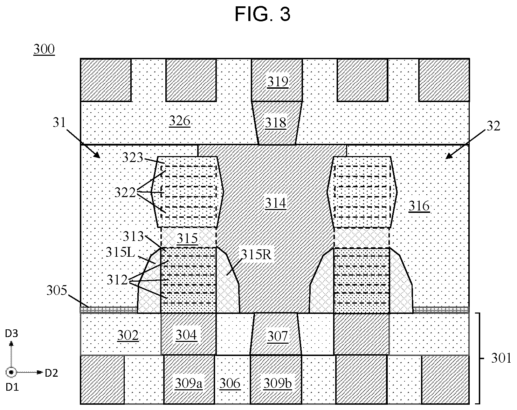

FIG. 3 illustrates a semiconductor device including a fill frontside contact structure formed between two stacked FET devices, according to one or more other embodiments.

Referring to FIG. 3, which is a cross-sectional view analogous to those shown in FIGS. 1B and 2B, a semiconductor device 300 may be formed of a 1^{st} stacked FET device 31 and a 2^{nd} stacked FET device 32 which are the same as or similar to the corresponding stacked FET devices 21 and 22 of the semiconductor device 200, respectively. For example, each of the two stacked FET devices 31 and 32 may include a 1^{st} channel structure 312, a 1^{st} source/drain pattern 313, a middle isolation layer 315 and side spacers 315L and 315R, a 2^{nd} channel structure 322, and a 2^{nd} source/drain pattern 323 which are the same as or similar to the corresponding structural elements of the semiconductor device 200. The semiconductor device 300 may also include a base layer 301 including STI structures 302 and a backside isolation structure 306 in which backside contact structures 304, a 1^{st} via structure 307 and a plurality of backside metal lines including backside metal lines 309a and 309b are formed. In addition, the semiconductor device 300 may include a 1^{st} front isolation structure 316 and a 2^{nd} frontside isolation structure 326 which includes a fill frontside contact structure 314, a 3^{rd} via structure 318 and frontside metal lines 319, respectively. A bottom liner 305 used as etch stop layer may be formed on portions of top surfaces of the STI structures 302. Since these structural elements of the semiconductor device 300 are the same as or similar to the corresponding ones of the semiconductor device 200, duplicate descriptions of the same structural elements may be omitted herein, and instead, different aspects of the semiconductor device 300 may be described herein.

The semiconductor device 300 may differ from the semiconductor device 200 in that the 1^{st} channel structures 312 and the 2^{nd} channel structure 322 may have the same number of nanosheet layers having the same widths in the D2 direction. The channel structures 312 and 322 may be formed to have the same widths because these two channel structures 312 and 322 are formed based on two stacked active patterns having same width, unlike the active patterns 210 and 220 of FIG. 2A having different widths.

In addition, there may be disposed two side spacers on side surfaces of the 1^{st} source/drain pattern 313, for example, a left side spacer 315L on a left side surface of the 1^{st} source/drain pattern 313 and a right side spacer 315R on a right side surface of the 1^{st} source/drain pattern 313. Unlike in the semiconductor devices 100 and 200 having two channel structures 112 and 122 having different number of nanosheet layers and different widths in the D2 direction, the same-size channel structures 312 and 322 of each of the stacked FET devices 31 and 32 may cause patterning of the middle isolation layer 315 to form two side spacers 315L and 315R as a residual structure of the middle isolation layer 315 when two active patterns having the same widths are patterned to provide a space where the two source/drain patterns 313 and 323 are to be formed.

Still, however, the fill frontside contact structure 314, which is the same as the fill frontside contact structure 214 of the semiconductor device 200, may fill in a space between the two stacked FET devices 31 and 32 in the D2 direction in a single deposition process. Thus, the fill frontside contact structure 314 may also contact an entire left side surface of the 1^{st} stacked FET device 31 and an entire right side surface of the 2^{nd} stacked FET device 32. For example, the fill frontside contact structure 314 may contact the entire side surfaces of the side spacers 315R and 315L, the middle isolation layers 315, and the 2^{nd} source/drain patterns 323 facing in the D2 direction like the fill frontside contact structure 214.

Provided herebelow is a method of manufacturing a semiconductor device in which a fill frontside contact structure is formed between two stacked FET devices having respective channel structures having different number of nanosheet layers and different widths.

FIGS. 4A-4L illustrate intermediate semiconductor devices obtained after respective steps of manufacturing a semiconductor device in which a fill frontside contact structure is formed between two stacked FET devices having respective channel structures having different number of nanosheet layers and different widths, according to one or more embodiments.

As the semiconductor device manufactured through the respective steps as shown in FIGS. 4A-4L may be the same as or may correspond to the semiconductor device 200 shown in FIGS. 2A and 2B, duplicate descriptions, including those about materials and structures, thereof may be omitted and the same reference numbers may be used in the descriptions herebelow.

Referring to FIG. 4A, an initial semiconductor stack 200' may be formed by epitaxially growing a plurality of semiconductor layers (nanosheet layers) on a substrate 201'.

The semiconductor layers may be epitaxially grown from the substrate 201' in the order of a lower stack including 1^{st} sacrificial layers 211 and 1^{st} channel layers 212 vertically stacked in an alternating manner, a middle sacrificial layer 215', and an upper stack including 2^{nd} sacrificial layers 221 and 2^{nd} channel layers 222 vertically stacked in an alternating manner on the middle sacrificial layer 215'.

While the substrate 201' and the channel layers 212 and 222 are formed of silicon (Si), the sacrificial layers 211, 215' and 221 may be formed of silicon germanium (SiGe) with respective Ge concentrations therein. The middle sacrificial layer 215' may have a higher Ge concentration than the 1^{st} and 2^{nd} sacrificial layers 211 and 221. For example, the middle sacrificial layer 215' may have a Ge concentration of 40-45%, and the 1^{st} and 2^{nd} sacrificial layers 211 and 221 may have a Ge concentration of 25-30%.

Here, the sacrificial layers 211, 215' and 221 are referred to as such because these layers will be removed and replaced by other layers or structures in later steps of manufacturing a semiconductor device from the initial semiconductor stack 200'

Referring to FIG. 4B, the initial semiconductor stack 200' including the substrate 201' may be patterned to obtain a 1^{st} semiconductor stack 21' and a 2^{nd} semiconductor stack 22' facing each other, and also, the substrate 201' may be patterned to form a shallow trench isolation (STI) structures 202 thereon.

The patterning of the initial semiconductor stack 200' into the two semiconductor stacks 21' and 22' may be performed such that an upper stack of each of the two semiconductor stacks 21' and 22' has a smaller width than a lower stack thereof with a middle sacrificial layer 215' thereon, and the two semiconductor stacks 21' and 22' face each other in the D2 direction with a 1^{st} recess R0 therebetween. For example, the patterning may be performed such that the lower stack is partially overlapped in the D3 direction. Further, the patterning may be performed such that a right side surface of the 1^{st} semiconductor stack 21' formed by right side surfaces of the lower stack, the middle sacrificial layer 215', and the upper stack thereof, which are vertically aligned or coplanar with each other, faces a left side surface of the 2^{nd} semiconductor stack 22' formed by left side surfaces of the lower stack, the middle sacrificial layer 215', the upper stack thereof, which are vertically aligned or coplanar with each other. Here, the lower stack and the upper stack of each of the semiconductor stacks 21' and 22' may refer to the 1^{st} active pattern 210 and the 2^{nd} active pattern 220 shown in FIG. 2A, respectively.

Further, the patterning of the substrate 201' may form a plurality of shallow trenches in the substrate at positions not overlapped by the two semiconductor stacks 21' and 22', and the shallow trenches may be filled with a low-k dielectric material such as silicon oxide (e.g., SiO₂), to form the STI structures 202 therein.

The patterning of the initial semiconductor stack 200' and the substrate 201' may be performed through, for example, drying etching (e.g., reactive ion etching (RIE)) based on a dummy gate structure with hard mask patterns thereon, and the formation of the STI structures 202 may be performed through, for example, chemical vapor deposition (CVD), plasma enhanced chemical vapor deposition (PECVD), physical vapor deposition (PVD), atomic layer deposition (ALD), plasma enhanced atomic layer deposition (PEALD), or a combination thereof.

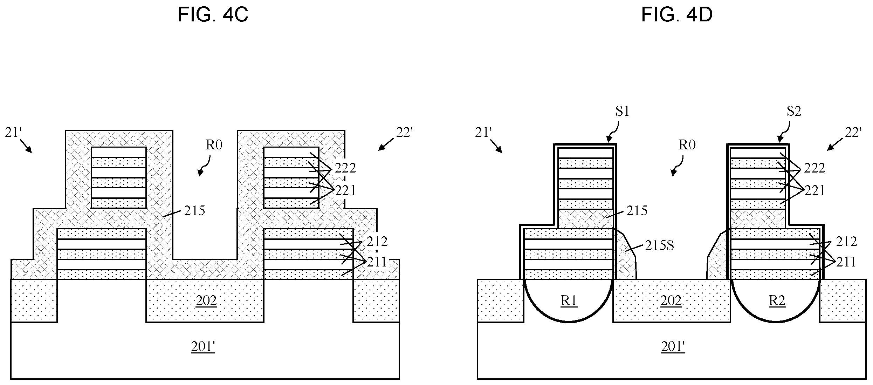

Referring to FIG. 4C, the middle sacrificial layer 215' may be removed and replaced by a middle isolation layer 215 surrounding the lower stack and the upper stack of each of the semiconductor stacks 21' and 22'.

The removal of the middle sacrificial layer 215' may be performed through, for example, wet etching using an etchant such as an ammonia-peroxide mixture which removes the middle sacrificial layer 215' of SiGe with a high Ge concentration while the channel layers 212 and 222 of silicon (Si) and the sacrificial layers 211 and 221 of SiGe with a low Ge concentration are not or minimally attacked by the etchant.

Further, an isolation material such as SiBCN, SiCN, SiOC, SiOCN, SiN, Si₃N₄, etc., may fill in a space from which the middle sacrificial layer 215' is removed, thereby forming a middle isolation layer 215. The formation of the middle isolation layer 215 may be performed through, for example, ALD or PEALD. At this time, the middle isolation layer 215 may be spread to conformally surround the outer profile of both the lower and upper stacks of each semiconductor stack 21' and 22' as well as the top surfaces of the STI structures 202.

The middle isolation layer 215 may be formed to isolate a channel structure to be formed from the lower stack and a channel structure to be formed from the upper stack in each of the semiconductor stack 21' and 22'.

Referring to FIG. 4D, each of the 1^{st} semiconductor stack 21' and the 2^{nd} semiconductor stack 22' may be patterned to form spaces where a lower source/drain pattern and an upper source/drain pattern thereabove are to be formed, and further, the substrate 201' exposed by the patterning of the semiconductor stacks 21' and 22' may be patterned to form placeholder recesses PR1 and PR2 therein. At this time, the middle isolation layer 215 may also be patterned to remain only between the lower stack and the upper stack of each of the semiconductor stacks 21' and 22' and at side surfaces of the lower stacks facing each other in the D2 direction as side spacers 215S.

The upper stack and the lower stack, that is, the 2^{nd} active pattern 220 and the 1^{st} active pattern 210 therebelow, of each of the semiconductor stacks 21' and 22' may be patterned through, for example, dry etching or wet etching between the gate structures 250 as shown in FIG. 2A to form therein spaces S1 and S2 where source/drain patterns for the 1^{st} semiconductor stack 21' and the 2^{nd} semiconductor stack 22' are to be formed in a later step.

When the upper stack and the lower stack are patterned to form the spaces S1 and S2, the middle isolation layer 215 surrounding the outer profile of the upper stack and the lower stack may also be patterned from top. Thus, the middle isolation layer 215 may be removed from top, left side and right side surfaces of the upper stack, a top surface of the lower stack not vertically overlapped by the upper stack, a left side surface of the lower stack and top surfaces of the STI structures 202. At this time, however, the middle isolation layer 215 may remain at a space between the upper stack and the lower stack without being patterned to isolate two channel structures to be formed from the upper stack and the lower stack in a later step. Further, the middle isolation layer 215 may also remain as a side spacer 215S at a side surface of the lower stack vertically aligned or coplanar with a side surface of the upper stack thereabove.

In the 1^{st} semiconductor stack 21', the middle isolation layer 215 may remain as the side spacer 215S at a right side surface of the lower stack vertically aligned or coplanar with a right side surface of the upper stack although an upper portion thereof may be partially removed. This residual structure of the middle isolation layer 215 may remain on the right side surface of the lower stack due to the different widths of the lower stack and the upper stack in the D2 direction and the aligned, coplanar side surfaces of the right side surfaces of the upper stack and the lower stack.

For example, when the space S1 for the upper source/drain pattern and the lower source/drain pattern is formed, the middle isolation layer 215 formed at the left side surface and the middle isolation layer 215 formed at the right side surface of the upper stack may be removed at the same time because these two portions of the middle isolation layer 215 have the same vertical length from the top surface. At this time, the middle isolation layer 215 formed at the left side surface of the lower stack may also be removed. This is because the left side surface of the lower stack is not overlapped by the upper stack, and thus, subjected to the patterning of the middle isolation layer 215 at the side surfaces of the upper stack at the same time. Moreover, the middle isolation layer 215 formed at the left side surface of the lower stack has a smaller vertical length than that formed at the side surfaces of the upper stack. Thus, the middle isolation layer 215 at the left side surface of the lower stack may be patterned earlier than the middle isolation layer 215 at the side surface of the upper stack when subjected to the same patterning at the same time.

When the middle isolation layer 215 is removed from the side surfaces of the upper stack, the middle isolation layer 215 formed at the top surface of the upper stack, the top surface of the lower stack not overlapped by the upper stack, and the top surfaces of the STI structures 202 may also be removed. This is because these portions of the middle isolation layer 215 are subjected to the same patterning of the middle isolation layer 215 at the side surfaces of the upper stack at the same time, and have a smaller vertical length than the middle isolation layer 215 at the side surfaces of the upper stack.

Thus, when the middle isolation layer 215 is removed from the top, left side and right side surfaces of the upper stack, the top surface of the lower stack not vertically overlapped by the upper stack, the left side surface of the lower stack and the top surfaces of the STI structures 202, the middle isolation layer 215 may still remain at the right side surface of the lower stack as the side spacer 215S.

For the same reasons described above, the middle isolation layer 215 formed in the 2^{nd} semiconductor stack 22' may remain in a space between the lower stack and the upper stack and at the left side surface of the lower stack as a side spacer 215S.

Subsequent to the patterning of the upper stack and the lower stack along with the middle isolation layer 215, the substrate 201' exposed below the space S1 and S2 formed by the patterning of the lower stack and the upper stack may be patterned to form the placeholder recesses R1 and R2 in which respective placeholder structures are to be formed in a next step. The placeholder structures are formed in these two placeholder recesses R1 and R2 to reserve spaces where backside contact structure connected to bottom surfaces of source/drain patterns are to be formed in a later step. The patterning operations to form the spaces S1 and S2 and the placeholder recesses R1 and R2 respectively therebelow may be performed through, for example, dry etching or wet etching.

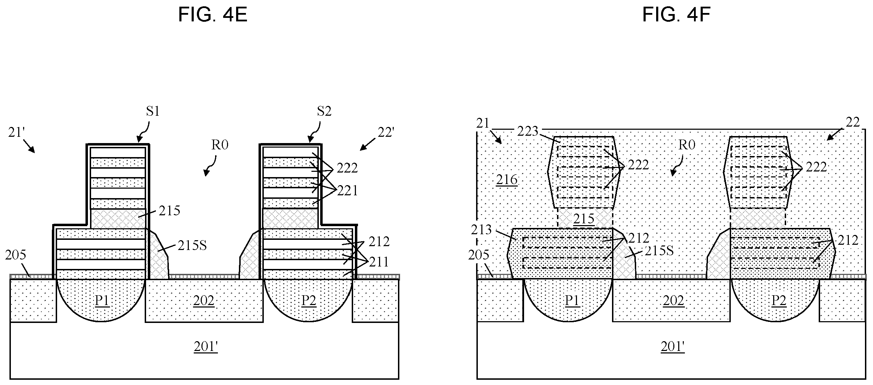

Referring to FIG. 4E, the placeholder recesses R1 and R2 may be filled in with placeholder structures P1 and P2, respectively.

The placeholder structures P1 and P2 may be epitaxially grown from the substrate 201' to be formed of silicon germanium (SiGe). Also, a bottom liner 205 may be formed on top surfaces of the STI structures 202 to be used as etch stop layer in a later step. A material forming the bottom liner 205 may be silicon nitride (SiN, Si₃N₄, etc.). The formation of the bottom liner 205 may be performed at a different step, for example, a later step after formation of source/drain patterns, according to one or more other embodiments.

Referring to FIG. 4F, a 1^{st} source/drain pattern 213 and a 2^{nd} source/drain pattern 223 may be formed in each of the spaces S1 and S2 obtained by the patterning of the lower stack and the upper stack in each of the semiconductor stacks 21' and 22' in the previous step, and a 1^{st} frontside isolation structure 216 may be formed to surround the semiconductor stacks 21' and 22', thereby forming a 1^{st} stacked FET device 21 and a 2^{nd} stacked FET device 22.

The 1^{st} source/drain pattern 213 may be epitaxially grown from the 1^{st} channel layers 212 of the lower stack while the 1^{st} sacrificial layers 211 are covered by inner spacers formed at side surfaces thereof in the D1 direction , and the 2^{nd} source/drain patterns 223 may be epitaxially grown from the 2^{nd} channel layers 222 of the upper stack while the 2^{nd} sacrificial layers 221 are covered by inner spacers formed at side surfaces thereof in the D1 direction . When the epitaxial growth of the source/drain patterns 213 and 223 is performed, n-type impurities such as phosphorus (P), arsenic (As), antimony (Sb), etc. may be in-situ doped in the epitaxial structure for the 1^{st} source/drain patterns 213, and p-type impurities such as boron (B), gallium (Ga), or indium (In), etc. may be in-situ doped in the epitaxial structure for the 2^{nd} source/drain pattern 223.

When the 1^{st} source/drain pattern 213 is grown from the 1^{st} channel layers 212 of the 1^{st} semiconductor stack 21', a right side surface of the 1^{st} source/drain pattern 213 may contact the side spacer 215S formed on the right side surface of the lower stack of the 1^{st} semiconductor stack 21'. In the same manner, a left side surface of the 1^{st} source/drain pattern 213 grown from the 1^{st} channel layers 212 of the 2^{nd} semiconductor stack 22' may contact the side spacer 215S formed on the left side surface of the lower stack of the 2^{nd} semiconductor stack 22'. Thus, an entire right side surface of one 1^{st} source/drain pattern 213 and an entire left side surface of the other 1^{st} source/drain pattern 213 may be covered by the respective side spacers 215S.

With the formation of the source/drain patterns 213 and 223, the 1^{st} frontside isolation structure 216 may be formed to surround the semiconductor stacks 21' and 22' to isolate the semiconductor stacks 21' and 22' from each other or other circuit elements. The 1^{st} frontside isolation structure 216 may be formed through, for example, deposition of a low-k material such as silicon oxide (e.g. SiO₂) using CVD, PVD, PECVD, etc. As the 1^{st} frontside isolation structure 216 surrounds the semiconductor stacks 21' and 22', the 1^{st} recess R0 formed therebetween may also be filled in with the 1^{st} frontside isolation structure 216.

Subsequent to the formation of the 1^{st} frontside isolation structure 216, the dummy gate structure surrounding the semiconductor stacks 21' and 22' and the sacrificial layers 211 and 221 may be removed and replaced by respective gate structures 250 surrounding the channel layers 212 and 222. Thus, the 1^{st} semiconductor stack 21' and the 2^{nd} semiconductor stack 22' may be formed as a 1^{st} stacked FET device 21 and a 2^{nd} stacked FET device 22, respectively, in each of which the lower stack forms an NFET and the upper stack forms a PFET.

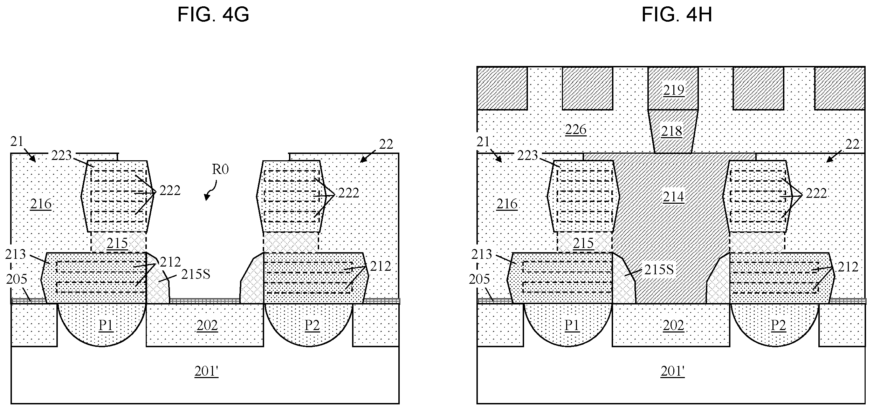

Referring to FIG. 4G, the 1^{st} frontside isolation structure 216 may be patterned to reopen the 1^{st} recess R0 between the stacked FET devices 21 and 22.

The patterning operation in this step may be performed such that the 1^{st} frontside isolation structure 216 formed in the 1^{st} recess R0 between the stacked FET devices 21 and 22 is removed so that the 1^{st} recess R0 exposes a right side surface of the 1^{st} stacked FET device 21 including the right side surfaces of the 2^{nd} source/drain pattern 223, the middle isolation layer 215 and the side spacer 215S thereof and the left side surface of the 2^{nd} stacked FET device 22 including the left side surfaces of the 2^{nd} source/drain pattern 223, the middle isolation layer 215 and the side spacer 215S thereof.

The patterning operation in this step may also expose to an outside a right portion of a top surface of the 2^{nd} source/drain pattern 223 of the 1^{st} stacked FET device 21 and a left portion of a top surface of the 2^{nd} source/drain pattern 223 of the 2^{nd} stacked FET device 22. Further, the bottom liner 205 on the top surface of the STI structure 202 between the two stacked FET devices 21 and 22 may also be exposed through the 1^{st} recess R0 as the patterning of the 1^{st} frontside isolation structure 216 may stop at a top surface of the bottom liner 205 as etch stop layer.

The patterning of the 1^{st} frontside isolation structure 216 in this step may be performed through, for example, dry etching or wet etching using an etchant such as hydrofluoric acid (HF), which may selectively remove silicon oxide (e.g. SiO₂) forming the 1^{st} frontside isolation structure 216 against silicon germanium (SiGe) forming the 2^{nd} source/drain pattern 223 of p-type, SiBCN forming the middle isolation layer 215, the side spacer 215S, and silicon nitride forming the bottom liner 205. Thus, the 1^{st} frontside isolation structure 216 may be patterned by this selective etching operation in a self-aligning manner.

Referring to FIG. 4H, a fill frontside contact structure 214 may fill in the 1^{st} recess R0 formed in the 1^{st} frontside isolation structure 216, and a back-end-of-line (BEOL) process may be performed thereon.

The fill frontside contact structure 214 may be filled in the 1^{st} recess R0 through, for example, depositing in the 1^{st} recess R0 metal or a metal compound, for example, tungsten (W), copper (Cu), aluminum (Al), molybdenum (Mo), ruthenium (Ru), etc., or a compound thereof, by CVD, PVD, PECVD, etc., or a combination thereof. Here, the deposition of the metal or metal compound may be a single deposition operation, and thus, no connection surface, interface, barrier or junction may be formed inside the fill frontside contact structure 214, unlike one that may be formed between the frontside contact structure 114 and the 2^{nd} via structure 117 of the semiconductor device 100 shown in FIG. 1B because these two metal structures may be formed at two different deposition steps.

Prior to the formation of the fill frontside contact structure 214 in the 1^{st} recess R0, the bottom liner 205 exposed therethrough may be removed through, for example, selective etching to expose the top surface of the STI structure 202. Subsequently, the metal or metal compound forming the fill frontside contact structure 214 may flow, for example, by flowable CVD, in the 1^{st} recess R0 from the exposed top surfaces of the 2^{nd} source/drain patterns 223 along the right side surface of the 1^{st} stacked FET device 21 and the left side surface of the 2^{nd} stacked FET device 22 down to the top surface of the STI structure 202. Thus, the fill frontside contact structure 214 may contact the right side surfaces of the 2^{nd} source/drain pattern 223, the middle isolation layer 215, and the side spacer 215S of the 1^{st} stacked FET device 21, the top surface of the STI structure 202, and the left side surfaces of the 2^{nd} source/drain pattern 223, the middle isolation layer 215, and the side spacer 215S of the 2^{nd} stacked FET device 22.

A silicide layer such as CoSi₂, NiSi₂, TiSi₂, or WSi₂, may be formed on the surfaces of the source/drain patterns 213 and 223 connected to the fill frontside contact structure 214 before the deposition of the metal or metal compound for the fill frontside contact structure 214 to reduce contact resistance between the metal or metal compound and silicon forming the source/drain patterns 213 and 223, according to one or more other embodiments.

In addition, a BEOL process may performed on a top surface of the 1^{st} frontside isolation structure 216 with the fill frontside contact structure 214 therein. The BEOL process may include formation of a 2^{nd} frontside isolation structure 226 on to the top surfaces of the 1^{st} frontside isolation structure 216 and the fill frontside contact structure 214 followed by formation of a frontside via structure 218 and a frontside metal line 219 thereon. The frontside metal line 219 may connect the 2^{nd} source/drain patterns 223 to another semiconductor device or circuit element through the fill frontside contact structure 214 and the frontside via structure 218.

The 2^{nd} frontside isolation structure 226 may be formed in a manner similar to that used to form the 1^{st} frontside isolation structure 216 based on the same or different low-k dielectric material of the 1^{st} frontside isolation structure 216. The frontside via structure 218 and the frontside metal line 219 may be formed in the 2^{nd} frontside isolation structure 226 through, for example, a damascene process or a direct etching operation, using metal or a metal compound which is the same as or different from that of the fill frontside contact structure 214.

In the meantime, when the 1^{st} recess R0 is formed in the previous step (FIG. 4G) and the fill frontside contact structure 214 is formed in the 1^{st} recess R0 in this step, another recess may also be formed in the 1^{st} frontside isolation structure 216 to form the common contact structure 224 therein (FIG. 2C).

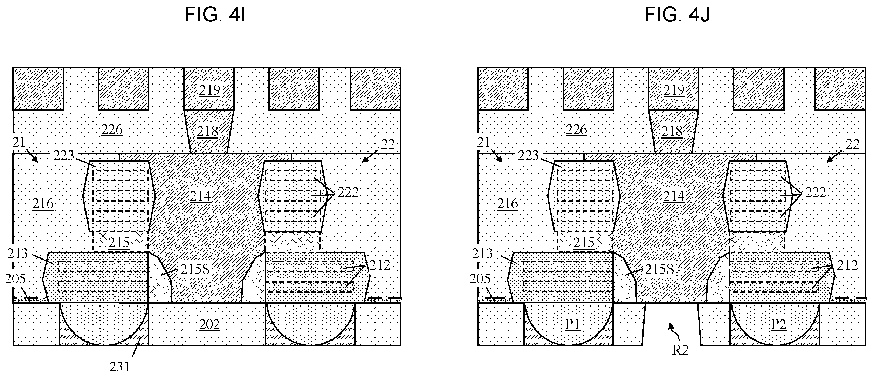

Referring to FIG. 4I, the substrate 201' may be removed to expose the placeholder structures P1 and P2, and a placeholder isolation structure 231 may be formed to surround the placeholder structures P1 and P2.

The removal of the substrate 201' may be performed through, for example, a backside thinning operation in which the substrate 201' is mechanically grinded followed by dry etching or wet etching, which removes the remaining substrate 201' including portions surrounding the placeholder structures P1 and P2. By the removal of the substrate 201', the STI structures 202 may be exposed to an outside.

After removal of the substrate 201', a space at a side of each of the placeholder structures P1 and P2 may be filled in with the placeholder isolation structure 231 which may be formed of an isolation material different from silicon oxide that forms the STI structures 202. For example, the placeholder isolation structure 231 may be formed of a material such as silicon nitride (e.g., SiN or Si₃N₄), SiC, SiCH or SiCOH. The placeholder isolation structure 231 may be formed to surround the placeholder structures P1 and P2 to protect the placeholder structures P1 and P2 in a subsequent etching operation to remove a portion of the STI structure 202 vertically below the fill frontside contact structure 214.

The backside process in this step, including the removal of the substrate 201' and the formation of the placeholder isolation structure 231, and the subsequent steps may be performed by forming a carrier substrate on a top surface of the intermediate semiconductor device obtained in the previous step and turning or flipping upside down this intermediate semiconductor device.

Referring to FIG. 4J, a portion of the STI structure 202 vertically below the fill frontside contact structure 214 may be removed to form a 2^{nd} recess R2 in the STI structure 202 to expose a bottom surface of the fill frontside contact structure 214.

The removal of the portion of the STI structure 202 in this step may be performed through, for example, dry etching or wet etching of the STI structure 202 at a position vertically below the fill frontside contact structure 214 using an etchant such as CF₄, CHF₃, C₄F₈, etc., which selectively etches silicon oxide (e.g. SiO₂) forming the STI structure 202 against the material (e.g., SiN, Si₃N₄, SiC, SiCH or SiCOH) forming the placeholder isolation structure 231.

According to one or more other embodiments, the substrate 201' of silicon (Si) instead of the STI structure 202 may be formed at the position vertically below the fill frontside contact structure 214 when the STI structures 202 are not formed at an entire upper portion of the substrate 201' between the two stacked FET devices 21 and 22 in the step of FIG. 4B. In this case, an etchant such as potassium peroxide (KOH) may be used to selectively etch silicon (Si) against the material forming the placeholder isolation structure 231.

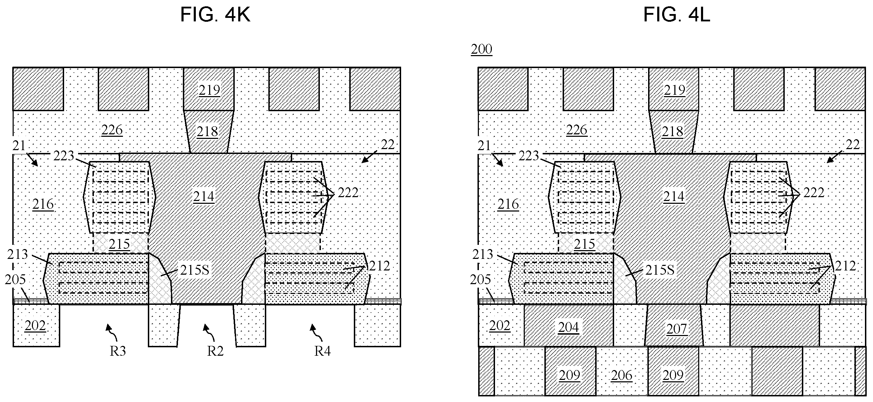

Referring to FIG. 4K, the placeholder isolation structure 231 and the placeholder structures P1 and P2 may be removed to form 3^{rd} and 4^{th} recesses R3 and R4 to expose bottom surfaces of the 1^{st} source/drain patterns 213.

The removal of the placeholder isolation structure 231 may be performed through, for example, dry etching or wet etching using an etchant such as phosphoric acid, which selectively etches the material (e.g., SiN, Si₃N₄, SiC, SiCH or SiCOH) forming the placeholder isolation structure 231 against silicon oxide (e.g. SiO₂) forming the STI structure 202. The removal of the placeholder structures P1 and P2 may be performed through, for example, dry etching or wet etching using an etchant such as an ammonia-peroxide mixture, which selectively etches the material (e.g., SiGe) forming the placeholder structures P1 and P2.

Referring to FIG. 4L, the recesses R2, R3 and R4 respectively exposing the bottom surfaces of the fill frontside contact structure 214 and the 1^{st} source/drain patterns 213 may be filled in with a backside via structure 207 and backside contact structures 204, respectively, followed by formation of a backside isolation structure 206 and backside metal lines 209a and 209b therein, thereby completing a semiconductor device 200.

Metal or a metal compound similar to that of the fill frontside contact structure 214 may fill in the recesses R2, R3 and R4 through, for example, CVD, PVD, PECVD, etc. to form the backside via structure 207 and the backside contact structures 204 at a vertically same level between the STI structures 202.

Subsequently, the backside isolation structure 206 formed of the same or similar material (e.g., SiO₂) forming the 1^{st} frontside isolation structure 216 may be formed on bottom surfaces the backside via structure 207 and the backside contact structures 204 through, for example, dry etching or wet etching followed by CVD, PVD, PECVD, etc. Further, a plurality of backside metal lines 209a and 209b may be formed in the backside isolation structure 206 through, for example, a damascene process or a direct etching operation, using metal or a metal compound which is the same as or different from that of the fill frontside contact structure 214.

Here, the backside via structure 207 may connect the fill frontside contact structure 214 to a positive voltage source or another circuit element for signal routing, and the backside contact structures 204 may connect the 1^{st} source/drain patterns 213 to a negative voltage source (or ground) or another circuit element for signal routing. For example, when the 1^{st} stacked FET device 21 and the 2^{nd} stacked FET device 22 may each form an inverter circuit, the 2^{nd} source/drain patterns 223 of the two stacked FET devices 21 and 22 may be commonly connected to the positive voltage source through the fill frontside contact structure 214, the backside via structure 207 and the backside metal line 209b therebelow. At this time, the 1^{st} source/drain patterns 213 of the two stacked FET devices 21 and 22 may be connected to the negative voltage source or ground through the backside contact structures 204 and the backside metal line 209a therebelow, respectively, to form the inverter circuit.

From the above embodiments, it is understood that even if the distance between the two stacked FET devices 21 and 22 are to be reduced in a semiconductor cell in response to demands for a high-density semiconductor device, formation of a contact structure for the 2^{nd} source/drain patterns 223 may be facilitated because the entire space, i.e., the 1^{st} recess R0, between the two stacked FET devices 21 and 22 is patterned (FIG. 4G) and metal or a metal compound to form the fill frontside contact structure 214 is filled in the entire space in the self-aligning manner (FIG. 4H). Thus, a process of manufacturing a semiconductor device can be simplified and the semiconductor device including the fill frontside contact structure 214 may have an improved connection performance due to the fill frontside contact structure having relatively a greater volume and reduced contact resistance.

Thus far, a method of manufacturing the semiconductor device 200 shown in FIGS. 2A and 2B has been described in reference to FIGS. 4A-4L. This method may also apply to manufacturing the semiconductor device 300 shown in FIG. 3, except that an initial semiconductor stack provided to form the semiconductor device 300 has the same number of nanosheet layers to form respectively channel structures, and this initial semiconductor stack is patterned such that a lower stack and an upper stack of each semiconductor stack (corresponding to the semiconductor stacks 21' and 22' of FIG. 4B) has the same width in the D2 direction. Thus, in forming the semiconductor device 300, a side spacer corresponding to the side spacer 215S of the semiconductor device 200 as shown in FIG. 4D is formed at both side surfaces of the lower stack (side spacers 315R and 315L in FIG. 3). Other than these differences, the method of manufacturing the semiconductor device 300 may be the same as the method of manufacturing the semiconductor device 200, and thus, duplicate descriptions thereof are omitted herein.

It is understood here that although particular materials, etchants and methods are described as being used to form various structural elements in the above embodiments, the disclosure is not limited thereto, and thus, other materials, etchants and methods may also be used to form the same structural elements to serve the same or similar purposes, according to one or more other embodiments.

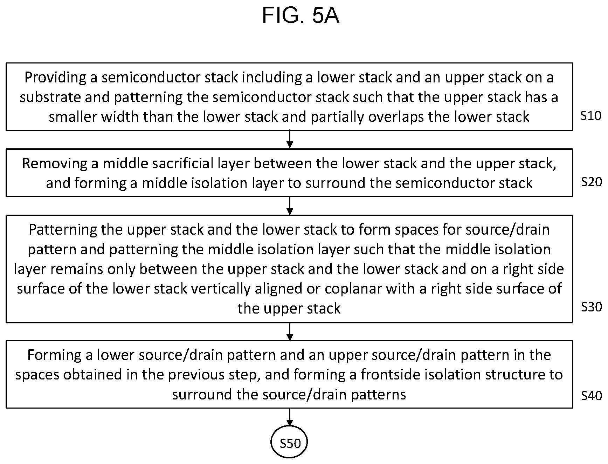

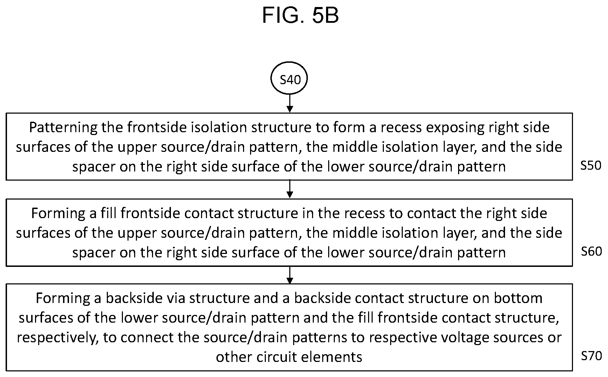

FIGS. 5A and 5B are a flowchart of manufacturing a semiconductor device including a stacked FET device in which a fill frontside contact structure is formed, according to one or more other embodiments.

The semiconductor device to be formed through the flowchart of FIGS. 5A and 5B may be the same or similar to the semiconductor device 200 manufactured in reference to FIGS. 4A-4L.

In step S10, a semiconductor stack including a lower stack and an upper stack to form a stacked FED device is provided on a substrate and the semiconductor stack may be patterned such that the upper stack has a smaller width than the lower stack and partially overlaps the lower stack. Here, the semiconductor stack including the lower stack and the upper stack may be or correspond to the semiconductor stack S21' shown in FIG. 4B.

Each of the lower stack and the upper stack may include a plurality of semiconductor layers epitaxially grown from the substrate of silicon (Si). The semiconductor layers may include a plurality of sacrificial layers of silicon germanium (SiGe) and a plurality of channel layers of silicon (Si). A middle sacrificial layer of SiGe having a higher Ge concentration than the sacrificial layers may be formed between the lower stack and the upper stack.

The patterning of the semiconductor stack may be performed such that a right side surface of the upper stack is vertically coplanar or aligned with a right side surface of the lower stack, while a left side surface of the upper stack contacts a top surface of the lower stack so that the left side surfaces of the upper stack and the lower stack are not vertically coplanar or aligned.

In step S20, the middle sacrificial layer may be removed and replaced by a middle isolation layer to isolate an upper channel structure and a lower channel structure respectively to be formed from the upper stack and the lower stack of the semiconductor stack.

The middle isolation layer may be formed to surround an outer profile of the semiconductor stack on the substrate in addition to a space between the upper stack and the lower stack from which the middle sacrificial layer is removed.

In step S30, the upper stack and the lower stack may be patterned to form spaces in which source/drain patterns are to be formed, at which time the middle isolation layer may be patterned to remain only between the upper stack and the lower stack and on the right side surface of the lower stack vertically aligned or coplanar with the right side surface of the upper stack.

When the upper stack and the lower stack are patterned to form the spaces for the source/drain patterns, the middle isolation layer on the top, left and right surfaces of the upper stack and a non-overlapped portion of a top surface of the lower stack may also be removed. However, due to the width difference and partial overlapping between the upper stack and the lower stack, the middle isolation layer may leave a residual structure as a side spacer on the right side surface of the lower stack.

In step S40, a lower source/drain pattern and an upper source/drain pattern may be formed in the spaces obtained in the previous step in the lower stack and the upper stack, respectively, and a frontside isolation structure is formed to surround the source/drain patterns followed by formation of a gate structure surrounding a channel structure in the lower stack and a channel structure in the upper stack.

Thus, the semiconductor stack including the channel structures in the lower stack and the upper stack, the lower source/drain pattern and the upper source/drain pattern, and the gate structure surrounding the channel structures may form a stacked FET device.

In step S50, the frontside isolation structure may be patterned to form a recess exposing a right side surface of the stacked FET device which is formed by right side surfaces of the upper source/drain pattern, the middle isolation layer, and the side spacer on the right side surface of the lower source/drain pattern.

In step S60, a fill frontside contact structure may be formed in the recess to contact the right side surface of the stacked FET device including the right side surfaces of the upper source/drain pattern, the middle isolation layer, and the side spacer on the right side surface of the lower source/drain pattern.

Thus, the fill frontside contact structure may become a source/drain contact structure of the upper source/drain pattern in the stacked FET device while being isolated from the lower source/drain pattern.

Here, when another semiconductor stack, which may be or correspond to the semiconductor stack S22' of FIG. 4B, is also provided on the substrate at a right side of the semiconductor stack described thus far, and subjected to the same processes in steps S10-S50, the recess formed in the frontside isolation structure may expose left side surfaces of a upper source/drain pattern, a middle isolation layer and a side spacer on a left side surface of a lower source/drain pattern in another stacked FET device formed from the other semiconductor stack. Further, the fill frontside contact structure may be formed to also contact the right side surface of the upper source/drain pattern while being isolated from the lower source/drain pattern in the other stacked FET device.

In step S70, a backside via structure and a backside contact structure may be formed on bottom surfaces of the lower source/drain pattern and the fill frontside contact structure, respectively, to connect the source/drain patterns to respective voltage sources or other circuit elements.

In the embodiments described above in references to FIGS. 1A and 1B to FIG. 5, each of the stacked FET devices is formed by an NFET at the lower stack and a PFET at the upper stack, and the NFET and the PFET are both implemented by a nanosheet transistor. However, the disclosure is not limited thereto. According to one or more other embodiments, the disclosure may apply to a stacked FET device including any one of a PFET or an NFET at the lower stack and the upper stack. Further, the disclosure may apply to different types of field-effect transistor such as FinFET, forksheet transistor, etc.

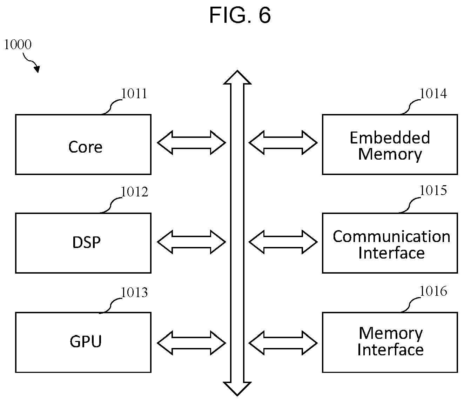

FIG. 6 is a schematic block diagram illustrating an electronic device including one or more semiconductor devices in which a plurality of different types of FET device are formed, according to one or more embodiments. The semiconductor devices of the electronic device may include one or more of the semiconductor devices shown in FIGS. 1A and 1B to FIG. 5, according to one or more embodiments.

Referring to FIG. 6, an SoC 1000 may be an integrated circuit in which components of a computing system or other electronic systems are integrated. As an example of the SoC 1000, an application processor (AP) may include at least one processor and components for various functions. The SoC 1000 may include a core 1011 (e.g., a processor), a digital signal processor (DSP) 1012, a graphic processing unit (GPU) 1013, an embedded memory 1014, a communication interface 1015, and a memory interface 1016. The components of the SoC 1000 may communicate with each other through a bus.

The core 1011 may process instructions and control operations of the components included in the SoC 1000. For example, the core 1011 may process a series of instructions to run an operating system and execute applications on the operating system. The DSP 1012 may generate useful data by processing digital signals (e.g., a digital signal provided from the communication interface 1015). The GPU 1013 may generate data for an image output by a display device from image data provided from the embedded memory 1014 or the memory interface 1016, or may encode the image data.

The embedded memory 1014 may store data necessary for the core 1011, the DSP 1012, and the GPU 1013 to operate. The communication interface 1015 may provide an interface for a communication network or one-to-one communication. The memory interface 1016 may provide an interface for an external memory of the SoC 1000, such as a dynamic random access memory (DRAM), a flash memory, etc.

At least one of the core 1011, the DSP 1012, the GPU 1013, and/or the embedded memory 1014 may include one or more of the semiconductor devices shown in FIGS. 1A and 1B to FIG. 5, according to one or more embodiments.

The foregoing is illustrative of example embodiments and is not to be construed as limiting the disclosure. Although a few example embodiments have been described, those skilled in the art will readily appreciate that many modifications are possible in the above embodiments without materially departing from the disclosure.

## Claims

1. A semiconductor device comprising:
a 1^{st} field-effect transistor, FET, comprising a 1^{st} source/drain pattern;
a 2^{nd} FET comprising a 2^{nd} source/drain pattern, vertically above the 1^{st} FET;
a 1^{st} side spacer on a right side surface of the 1^{st} source/drain pattern, the 1^{st} side spacer comprising an isolation material; and
a frontside contact structure on a right side surface of the 2^{nd} source/drain pattern and a right side surface of the 1^{st} side spacer,
wherein the frontside contact structure is connected to the 2^{nd} source/drain pattern and is isolated from the 1^{st} source/drain pattern by the 1^{st} side spacer.

2. The semiconductor device of claim 1, wherein the frontside contact structure is a single continuum metal structure.

3. The semiconductor device of claim 1 or 2, wherein the frontside contact structure is on the entirety of the right side surface of the 2^{nd} source/drain pattern.

4. The semiconductor device of any one of claims 1 to 3, wherein the frontside contact structure is on the entirety of the right side surface of the 1^{st} side spacer.

5. The semiconductor device of any one of claims 1 to 4, wherein a left side surface of the 1^{st} source/drain pattern is not vertically overlapped by the 2^{nd} source/drain pattern.

6. The semiconductor device of any one of claims 1 to 5, further comprising:
a frontside via structure or a frontside metal line vertically above a level of a top surface of the 2^{nd} source/drain pattern,
wherein the frontside contact structure is connected to the frontside via structure or the frontside metal line.

7. The semiconductor device of any one of claims 1 to 6, further comprising:
a backside via structure or a backside metal line vertically below a level of a top surface of the 1^{st} source/drain pattern,
wherein the frontside contact structure is connected to the backside via structure or the backside metal line.

8. The semiconductor device of any one of claims 1 to 7, further comprising:
a 3^{rd} FET comprising a 3^{rd} source/drain pattern;
a 4^{th} FET comprising a 4^{th} source/drain pattern, vertically above the 3^{rd} FET; and
a 2^{nd} side spacer on a left surface of the 3^{rd} source/drain pattern,
wherein the frontside contact structure is on a left surface of the 4^{th} source/drain pattern and a left surface of the 2^{nd} side spacer,
wherein the frontside contact structure is connected to the 4^{th} source/drain pattern and is isolated from the 3^{rd} source/drain pattern by the 2^{nd} side spacer.

9. The semiconductor device of claim 8, wherein the frontside contact structure is on the entirety of the left side surface of the 4^{th} source/drain pattern.

10. The semiconductor device of claim 8 or 9, wherein the frontside contact structure is on the entirety of the left side surface of the 2^{nd} side spacer.

11. The semiconductor device of any one of claims 8 to 10, wherein a right side surface of the 3^{rd} source/drain pattern is not vertically overlapped by the 4^{th} source/drain pattern.

12. The semiconductor device of any one of claims 8 to 11, wherein the 3^{rd} source/drain pattern has a greater width than the 4^{th} source/drain pattern.
